# EUROPÄISCHE PATENTSCHRIFT

(11) **EP 3 607 360 B1**
(45) Veröffentlichungstag und Bekanntmachung des Hinweises auf die Patenterteilung: **17.08.2022**
(21) Anmeldenummer: 18711603.3
(22) Anmeldetag: 26.03.2018
(51) Int. Cl.: G01V 3/08, G01V 3/10

(54) **VORRICHTUNG UND VERFAHREN ZUM DETEKTIEREN VON ELEKTRISCH LEITENDEN MESSOBJEKTEN IN EINEM UNTERGRUND**
DEVICE AND METHOD FOR DETECTING ELECTRICALLY CONDUCTIVE MEASUREMENT OBJECTS IN AN UNDERGROUND
DISPOSITIF ET PROCÉDÉ DE DÉTECTION D'OBJETS DE MESURE ÉLECTROCONDUCTEURS DANS UN SOUS-SOL

(30) Priorität: 05.04.2017 EP 17165035
(43) Veröffentlichungstag der Anmeldung: 12.02.2020
(73) Patentinhaber: Hilti Aktiengesellschaft, 9494 Schaan (LI)
(72) Erfinder: GOGOLLA, Torsten, 9494 Schaan (LI); SCHOENBECK, Dietmar, 6811 Goefis (AT); KALUSCHE, Geert, 9472 Grabs (CH); WUERSCH, Christoph, 9470 Werdenberg (CH)
(74) Vertreter: Hilti Aktiengesellschaft Corporate Intellectual Property
(86) Internationale Anmeldenummer: PCT/EP2018/057576
(87) Internationale Veröffentlichungsnummer: WO 2018/184880

(56) Entgegenhaltungen:
- DE-A1-102013 209 805
- DE-C1- 4 424 058
- US-A- 4 992 741
- US-A1- 2014 218 036
- US-B1- 6 541 966

## Beschreibung

### Technisches Gebiet

Die vorliegende Erfindung betrifft eine Vorrichtung zum Detektieren von elektrisch leitenden Messobjekten in einem Untergrund gemäß dem Oberbegriff des Anspruchs 1 sowie ein Verfahren zum Detektieren von elektrisch leitenden Messobjekten in einem Untergrund mit einer solchen Vorrichtung gemäß dem Oberbegriff des Anspruchs 12.

### Stand der Technik

Die Firma Proceq SA vertreibt unter dem Produktnamen "Profometer" eine Vorrichtung zum Detektieren von metallischen Messobjekten in einem Untergrund. Die Vorrichtung umfasst ein Gehäuse, eine Magnetspuleneinrichtung mit einer Sendespuleneinrichtung, die mindestens eine Sendespule aufweist, und eine Empfangsspuleneinrichtung, die mindestens eine Empfangsspule aufweist, eine Steuereinrichtung und eine Auswerteeinrichtung. Die Steuereinrichtung ist mit der Magnetspuleneinrichtung verbunden und zum Steuern der Sende- und Empfangsspuleneinrichtung ausgebildet. Die Auswerteeinrichtung ist mit der Magnetspuleneinrichtung verbunden und zum Auswerten einer in mindestens einer Empfangsspule der Empfangsspuleneinrichtung induzierten Spannung ausgebildet.

Das Profometer PM-6 arbeitet mit einem Messverfahren, das elektromagnetische Impulse zum Detektieren von Bewehrungsstäben nutzt. Durch mehrere Sendespulen werden periodisch Stromimpulse gesendet, so dass die Sendespulen ein Magnetfeld aufbauen. In elektrisch leitenden Materialien, die sich in dem Magnetfeld befinden, werden durch Induktion elektrische Ströme (Wirbelströme) induziert, die wiederrum ein sekundäres Magnetfeld erzeugen. Das sekundäre Magnetfeld erzeugt in den Empfangsspulen der Magnetspuleneinrichtung Messsignale, die von der Auswerteeinrichtung ausgewertet werden. In der Bedienungsanleitung des Profometer PM-6 wird darauf hingewiesen, dass sich elektrisch nicht-leitende Materialien wie Beton, Holz, Kunststoff oder Ziegel, die sich innerhalb des Magnetfelds befinden, nicht auf die Messergebnisse auswirken. Befinden sich hingegen elektrisch leitende Materialien innerhalb des Magnetfelds, ist von Einflüssen auf die Messergebnisse des Profometer PM-6 auszugehen.

Die Magnetspuleneinrichtung ist beim Profometer PM-6 in einer separaten Messsonde angeordnet und dadurch räumlich von der Steuereinrichtung, der Auswerteeinrichtung und einer Anzeigeeinrichtung getrennt. Durch die räumliche Trennung der Magnetspuleneinrichtung kann der Einfluss auf die Messergebnisse durch elektrisch leitende Materialien reduziert werden. Nachteilig ist, dass die Messergebnisse beim Profometer PM-6 durch elektrisch leitende Fremdobjekte, wie Armbanduhren oder Ringe, die der Bediener trägt, beeinflusst werden können. Der Bediener greift die Messsonde mit der Hand, so dass sich eine Armbanduhr oder ein Ring in kurzer Entfernung zur Magnetspuleneinrichtung befindet und die Messergebnisse stark beeinflussen kann.

US 2014/0218036 A1 offenbart eine Vorrichtung zum Detektieren von elektrisch leitenden Messobjekten. Die Vorrichtung umfasst ein Gehäuse, eine Magnetspuleneinrichtung, die eine Sendespuleneinrichtung und eine Empfangsspuleneinrichtung aufweist, eine Steuereinrichtung, die mit der Magnetspuleneinrichtung verbunden und zur Steuerung der Magnetspuleneinrichtung ausgebildet ist, und eine Auswerteinrichtung, die mit der Magnetspuleneinrichtung verbunden und zur Auswertung einer in der Empfangsspuleneinrichtung induzierten Spannung ausgebildet ist.

DE 10 2013 209 805 A1 offenbart eine weitere Vorrichtung zum Detektieren von elektrisch leitenden Messobjekten. Die Vorrichtung umfasst ein Gehäuse, eine Magnetspuleneinrichtung, die eine Sendespuleneinrichtung und eine Empfangsspuleneinrichtung aufweist, eine Steuereinrichtung, die mit der Magnetspuleneinrichtung verbunden und zur Steuerung der Magnetspuleneinrichtung ausgebildet ist, und eine Auswerteinrichtung, die mit der Magnetspuleneinrichtung verbunden und zur Auswertung einer in der Empfangsspuleneinrichtung induzierten Spannung ausgebildet ist. Die Empfindlichkeit der Empfangsspuleneinrichtung wird durch ein magnetisches Abschirmmittel verbessert, das zwischen der Sendespuleneinrichtung und Empfangsspuleneinrichtung angeordnet wird und die Empfangsspuleneinrichtung zumindest teilweise gegen ein direkt übertretendes Magnetfeld der Sendespuleneinrichtung abschirmt.

Aus US 2014/0218036 A1 und DE 10 2013 209 805 A1 sind keine Massnahmen bekannt, um den Einfluss von elektrisch leitenden Fremdobjekten und elektrisch leitenden Störobjekten auf die Messergebnisse zu reduzieren.

### Darstellung der Erfindung

Die Aufgabe der vorliegenden Erfindung besteht darin, eine Vorrichtung und ein Verfahren zum Detektieren von elektrisch leitenden Messobjekten in einem Untergrund dahingehend weiterzuentwickeln, dass der Einfluss von elektrisch leitenden Fremd- und Störobjekten auf die Messergebnisse reduziert ist. Außerdem sollen sämtliche Gerätekomponenten der Vorrichtung in einem Gehäuse angeordnet werden können.

Diese Aufgabe wird bei der eingangs genannten Vorrichtung zum Detektieren von elektrisch leitenden Messobjekten in einem Untergrund erfindungsgemäß durch die Merkmale des unabhängigen Anspruchs 1 und bei dem eingangs genannten Verfahren zum Detektieren von elektrisch leitenden Messobjekten in einem Untergrund erfindungsgemäß durch die Merkmale des unabhängigen Anspruchs 12 gelöst. Vorteilhafte Weiterbildungen sind in den abhängigen Ansprüchen angegeben.

Die Vorrichtung zum Detektieren von elektrisch leitenden Messobjekten in einem Untergrund ist erfindungsgemäß dadurch gekennzeichnet, dass im Gehäuse ein Metallblech mit einer Blechdicke d vorgesehen ist, wobei das Metallblech im Messbetrieb im Wesentlichen parallel zur Oberfläche des Untergrundes angeordnet ist, die Magnetspuleneinrichtung auf einer im Messbetrieb dem Untergrund zugewandten Unterseite des Metallblechs angeordnet ist und die Steuereinrichtung auf einer im Messbetrieb dem Untergrund abgewandten Oberseite des Metallblechs angeordnet ist. Die Idee der vorliegenden Erfindung besteht darin, durch ein Metallblech den Einfluss von elektrisch leitenden Fremdobjekten und elektrisch leitenden Störobjekten auf die Messergebnisse zu reduzieren. Das Metallblech trennt die Magnetspuleneinrichtung, die im Messbetrieb auf der Unterseite des Metallblechs angeordnet ist, räumlich von der Steuereinrichtung, die im Messbetrieb auf der Oberseite des Metallblechs angeordnet ist. Als Unterseite wird die dem zu detektierenden Untergrund zugewandte Seite des Metallblechs bezeichnet und als Oberseite wird die dem zu detektierenden Untergrund abgewandte Seite des Metallblechs bezeichnet.

Die erfindungsgemäße Vorrichtung zum Detektieren von elektrisch leitenden Messobjekten umfasst eine Magnetspuleneinrichtung, die eine Sendespuleneinrichtung und eine Empfangsspuleneinrichtung aufweist, eine Steuereinrichtung, die mit der Magnetspuleneinrichtung verbunden und zur Steuerung der Magnetspuleneinrichtung ausgebildet ist, und eine Auswerteinrichtung, die mit der Magnetspuleneinrichtung verbunden und zur Auswertung einer in der Empfangsspuleneinrichtung induzierten Spannung ausgebildet ist. Dabei werden unter dem Begriff "Steuereinrichtung" sämtliche Komponenten zur Steuerung der Magnetspuleneinrichtung, wie Stromquelle und Schaltungstransistor, und unter dem Begriff "Auswerteeinrichtung" sämtliche Komponenten zur Signal- und Messwertverarbeitung, wie Verstärker, Filter oder Analog-Digital-Wandler, zusammengefasst. Die Steuereinrichtung und Auswerteinrichtung umfassen elektronische Bauteile, die auf einer Leiterplatte befestigt werden, wobei die Steuer- und Auswerteinrichtung auf einer gemeinsamen Leiterplatte oder auf verschiedenen Leiterplatten angeordnet sein können. Eine Leiterplatte besteht aus elektrisch isolierendem Material mit leitenden Verbindungen (Leiterbahnen), sie dient zur mechanischen Befestigung und zur elektrischen Verbindung der elektronischen Bauteile. Sowohl die Leiterbahnen, die aus Kupfer bestehen, als auch die elektronischen Bauteile weisen zahlreiche elektrisch leitende Materialien auf, in denen Wirbelströme erzeugt werden und die die Messergebnisse beeinflussen.

Die vorliegende Erfindung unterscheidet zwischen den Begriffen "elektrisch leitende Messobjekte", "elektrisch leitende Fremdobjekte" und "elektrisch leitende Störobjekte". Unter dem Begriff "elektrisch leitende Messobjekte" werden sämtliche Objekte zusammengefasst, die in dem zu untersuchenden Untergrund eingebettet sind und von der erfindungsgemäßen Vorrichtung erfasst werden sollen. Als "elektrisch leitende Fremdobjekte" werden sämtliche Objekte bezeichnet, die außerhalb des zu untersuchenden Untergrunds und außerhalb des Gehäuses der erfindungsgemäßen Vorrichtung angeordnet sind. Unter dem Begriff "elektrisch leitende Störobjekte" werden sämtliche Objekte zusammengefasst, die innerhalb des Gehäuses der erfindungsgemäßen Vorrichtung angeordnet oder am Gehäuse der erfindungsgemäßen Vorrichtung angebracht sind. Objekte werden als elektrisch leitende Objekte bezeichnet, wenn die elektrische Leitfähigkeit grösser als 10⁶ S/m ist.

Im Messbetrieb der erfindungsgemäßen Vorrichtung werden die Sendespulen der Sendespuleneinrichtung von einem Strom I durchflossen und erzeugen ein primäres Magnetfeld. Der Strom I wird zu einem Abschaltzeitpunkt t₀ von der Steuereinrichtung abgeschaltet und das primäre Magnetfeld der Sendespuleneinrichtung klingt ab. Beim Ein- und Ausschalten des Stromes I entstehen durch das sich verändernde primäre Magnetfeld der Sendespuleneinrichtung in elektrisch leitenden Fremd- und Störobjekten Wirbelströme, die sekundäre Magnetfelder erzeugen. Dabei stellt das Metallblech selbst ein elektrisch leitendes Störobjekt dar. Das primäre Magnetfeld der Sendespuleneinrichtung und die durch Wirbelströme entstehenden sekundären Magnetfeldern werden zu einem resultierenden Magnetfeld überlagert. Die Aufnahme der Messsignale in der Empfangsspuleneinrichtung erfolgt nach dem Abschalten des Stromes I in der Sendespuleneinrichtung. Beim Abschalten des Stromes I entstehen in elektrisch leitenden Fremd- und Störobjekten auf der Oberseite des Metallblechs Wirbelströme, deren sekundäre Magnetfelder dem primären Magnetfeld der Sendespuleneinrichtung gleichgerichtet sind. Die sekundären Magnetfelder erzeugen ihrerseits im Metallblech Wirbelströme, deren Magnetfelder den sekundären Magnetfeldern entgegengerichtet sind und das resultierende Magnetfeld abschwächen.

Je schwächer das resultierende Magnetfeld oberhalb der Magnetspuleneinrichtung ist, umso geringer ist der Einfluss von elektrisch leitenden Fremd- und Störobjekten auf die Messergebnisse der erfindungsgemäßen Vorrichtung. Das resultierende Magnetfeld auf der Unterseite des Metallblechs induziert in den Empfangsspulen der Empfangsspuleneinrichtung Spannungen, die von der Auswerteeinrichtung als Messsignale aufgenommen und ausgewertet werden. Über die Materialauswahl und die Blechdicke des Metallblechs kann das resultierende Magnetfeld, das auf elektrisch leitende Fremd- und Störobjekte auf der Oberseite des Metallblechs wirkt, beeinflusst werden. Die Wirkung des Metallblechs ist von der elektrischen Leitfähigkeit und der magnetischen Permeabilität des verwendeten metallischen Materials abhängig, außerdem beeinflusst die Blechdicke die Wirkung des Metallblechs.

In einer bevorzugten Ausführung umfasst die Auswerteeinrichtung eine erste Auswerteeinrichtung, die die Messsignale der Empfangsspuleneinrichtung aufbereitet, und eine zweite Auswerteeinrichtung, die die aufbereiteten Messsignale auswertet, wobei die erste Auswerteeinrichtung auf der im Messbetrieb dem Untergrund abgewandten Oberseite des Metallblechs angeordnet ist. Die erste Auswerteeinrichtung ist mit der Empfangsspuleneinrichtung verbunden und führt eine Aufbereitung der Messsignale durch. Dazu gehören Verstärker, Filter oder Analog-Digital-Wandler. Die erste Auswerteeinrichtung stellt ein elektrisch leitendes Störobjekt dar, das die Messergebnisse der Vorrichtung negativ beeinflusst. Durch die Anordnung der ersten Auswerteeinrichtung auf der Oberseite des Metallblechs wird der negative Einfluss auf die Messergebnisse reduziert.

In einer ersten besonders bevorzugten Variante ist die zweite Auswerteeinrichtung auf der im Messbetrieb dem Untergrund abgewandten Oberseite des Metallblechs angeordnet. Die zweite Auswerteeinrichtung ist mit der ersten Auswerteeinrichtung verbunden und führt eine Auswertung der aufbereiteten Messsignale durch. Die zweite Auswerteeinrichtung stellt ein elektrisch leitendes Störobjekt dar, das die Messergebnisse der Vorrichtung negativ beeinflusst. Durch die Anordnung der zweiten Auswerteeinrichtung auf der Oberseite des Metallblechs wird der negative Einfluss auf die Messergebnisse reduziert. Außerdem ermöglicht die Anordnung der zweiten Auswerteeinrichtung im Gehäuse den Aufbau einer einteiligen Vorrichtung, bei der sämtliche Gerätekomponenten im Gehäuse angeordnet werden können.

In einer zweiten besonders bevorzugten Variante ist die zweite Auswerteeinrichtung außerhalb des Gehäuses angeordnet, wobei die erste und zweite Auswerteeinrichtung über eine Kommunikationsverbindung verbindbar sind. Die erste Auswerteeinrichtung führt eine Aufbereitung der Messsignale durch, die aufbereiteten Messsignale werden über die Kommunikationsverbindung an die zweite Auswerteeinrichtung übertragen und die zweite Auswerteeinrichtung führt eine Auswertung der aufbereiteten Messsignale durch. Die Kommunikationsverbindung kann als kabellose oder kabelgebundene Kommunikationsverbindung ausgebildet sein. Die zweite Variante bietet sich an, wenn die Vorrichtung zweiteilig ausgebildet ist. Gerätekomponenten, die aus dem Gehäuse ausgelagert werden können, reduzieren das Gewicht und ermöglichen den Aufbau eines kompakten Gehäuses, das über den zu detektierenden Untergrund bewegt wird.

Bevorzugt umschließt das Gehäuse einen Innenraum und das Metallblech unterteilt den Innenraum in einen unteren Teilbereich und einen oberen Teilbereich, wobei die Magnetspuleneinrichtung im unteren Teilbereich des Innenraums angeordnet ist und die Steuereinrichtung und die erste Auswerteeinrichtung im oberen Teilbereich des Innenraums angeordnet sind. Das Metallblech trennt die Magnetspuleneinrichtung, die sich im unteren Teilbereich befindet, von der Steuereinrichtung und der Auswerteeinrichtung, die sich im oberen Teilbereich befinden. Im Messbetrieb der Vorrichtung erzeugen Wirbelströme im Metallblech sekundäre Magnetfelder, die den Einfluss von elektrisch leitenden Fremd- und Störobjekten auf die Messergebnisse der erfindungsgemäßen Vorrichtung reduzieren. Durch die Anordnung der Steuereinrichtung und der ersten Auswerteeinrichtung im oberen Teilbereich des Gehäuses ist ihr Einfluss auf die Messergebnisse reduziert.

Bevorzugt umfasst die Vorrichtung eine Anzeigeeinrichtung mit einem Display, das zur Anzeige eines von der zweiten Auswerteeinrichtung berechneten Messergebnisses ausgebildet ist, wobei das Display auf der im Messbetrieb dem Untergrund abgewandten Oberseite des Metallblechs angeordnet ist. Die Anzeigeeinrichtung mit Display weist zahlreiche elektrisch leitende Materialien auf, die die Messergebnisse der Vorrichtung negativ beeinflussen können, und wird bei der erfindungsgemäßen Vorrichtung auf der Oberseite des Metallblechs angeordnet. Dabei kann das Display in das Gehäuse eingelassen werden oder auf dem Gehäuse befestigt werden. Das Metallblech ermöglicht den Aufbau einer einteiligen Vorrichtung mit einem großen Display.

Bevorzugt umfasst die Vorrichtung eine Speichereinrichtung, die mit der zweiten Auswerteeinrichtung verbunden ist und in der ein Kalibrationssignal gespeichert ist, wobei das Kalibrationssignal in Abwesenheit von elektrisch leitenden Messobjekten ermittelt wurde. Das Kalibrationssignal wird mit Hilfe der erfindungsgemäßen Vorrichtung in Abwesenheit von elektrisch leitenden Messobjekten ermittelt und in der Speichereinrichtung gespeichert. Das Messverfahren arbeitet mit einem Differenzsignal, das als Differenz aus einem Messsignal und dem gespeicherten Kalibrationssignal gebildet wird. Die Verwendung des Differenzsignals hat den Vorteil, dass Effekte, wie Sekundärfelder von elektrisch leitenden Störobjekten, durch die Differenzbildung eliminiert werden.

Die Wirkung des Metallblechs ist unter anderem von der elektrischen Leitfähigkeit σ des verwendeten Metalls, der magnetischen Permeabilität µ des verwendeten Metalls und der Blechdicke d abhängig. Die elektrische Leitfähigkeit σ und magnetische Permeabilität µ werden durch die Auswahl eines Metalls festgelegt, die Blechdicke d kann bei festgelegtem Metall verändert werden. Unter dem Begriff "Metall" werden reine Metalle und Metalllegierungen zusammengefasst. Über die Auswahl der Parameter elektrische Leitfähigkeit σ, magnetische Permeabilität µ und Blechdicke d kann die Wirkung des Metallblechs an die erfindungsgemäße Vorrichtung angepasst werden. Aluminium und Kupfer sind als Metalle für das Metallblech besonders geeignet. Dabei werden unter dem Begriff "Aluminium" reines Aluminium und Aluminiumlegierungen und unter dem Begriff "Kupfer" reines Kupfer und Kupferlegierungen zusammengefasst.

In einer ersten bevorzugten Ausführung ist das Metallblech aus Aluminium aufgebaut, wobei das Metallblech eine Blechdicke d von mindestens 1,0 mm aufweist. Durch die Wahl von Aluminium als Metall sind die elektrische Leitfähigkeit und die magnetische Permeabilität des Metallblechs, das auch als Aluminiumblech bezeichnet wird, festgelegt und die kompensierende Wirkung des Metallblechs kann über die Blechdicke verändert werden. Bei Verwendung von Aluminiumblechen ist eine Blechdicke von mindestens 1,0 mm erforderlich. Bei Aluminiumblechen mit Blechdicken von mindestens 1,0 mm sorgt das Aluminiumblech dafür, dass die Amplituden der Empfangssignale für Zeitverschiebungen Δt kleiner als 10 µs nach dem Abschaltzeitpunkt t₀ des Stromes von der Auswerteeinrichtung messbar sind. Damit die Empfangssignale von der Auswerteeinrichtung messbar sind, müssen die Empfangssignale unterhalb der Übersteuerungsgrenze der Auswerteeinrichtung liegen.

Besonders bevorzugt weist das Metallblech (Aluminiumblech) eine Blechdicke d von mindestens 2 mm auf. Eine Blechdicke des Aluminiumblechs von mindestens 2,0 mm sorgt dafür, dass die Amplituden der Empfangssignale für Zeitverschiebungen Δt grösser als 5 µs nach dem Abschaltzeitpunkt t₀ des Stromes von der Auswerteeinrichtung messbar sind.

In einer zweiten bevorzugten Ausführung ist das Metallblech aus Kupfer aufgebaut, wobei das Metallblech eine Blechdicke d von mindestens 0,4 mm aufweist. Durch die Wahl von Kupfer als Metall sind die elektrische Leitfähigkeit und die magnetische Permeabilität des Metallblechs, das auch als Kupferblech bezeichnet wird, festgelegt und die kompensierende Wirkung des Metallblechs kann über die Blechdicke verändert werden. Bei Verwendung von Kupferblechen ist eine Blechdicke von mindestens 0,4 mm erforderlich. Bei Kupferblechen mit Blechdicken von mindestens 0,4 mm sorgt das Kupferblech dafür, dass die Amplituden der Empfangssignale für Zeitverschiebungen Δt kleiner als 10 µs nach dem Abschaltzeitpunkt t₀ des Stromes von der Auswerteeinrichtung messbar sind. Damit die Empfangssignale von der Auswerteeinrichtung messbar sind, müssen die Empfangssignale unterhalb der Übersteuerungsgrenze der Auswerteeinrichtung liegen.

Besonders bevorzugt weist das Metallblech (Kupferblech) eine Blechdicke d von mindestens 0,8 mm auf. Eine Blechdicke des Kupferblechs von mindestens 0,8 mm sorgt dafür, dass die Amplituden der Empfangssignale für Zeitverschiebungen Δt grösser als 5 µs nach dem Abschaltzeitpunkt t₀ des Stromes von der Auswerteeinrichtung messbar sind.

Ein Verfahren zum Detektieren von elektrisch leitenden Messobjekten in einem Untergrund mit der erfindungsgemäßen Vorrichtung, die eine Sendespuleneinrichtung, eine Empfangsspuleneinrichtung, eine Steuereinrichtung und eine Auswerteeinrichtung umfasst, weist eine Schrittfolge auf mit den Schritten:
▪ mindestens eine Sendespule der Sendespuleneinrichtung wird von einem Strom I durchflossen,
▪ der Strom I wird zu einem Abschaltzeitpunkt t₀ von der Steuereinrichtung abgeschaltet,
▪ eine, in mindestens einer Empfangsspule der Empfangsspuleneinrichtung induzierte, Spannung wird von der Auswerteeinrichtung mit einer Zeitverschiebung Δt nach dem Abschaltzeitpunkt t₀ des Stromes I als Messsignal aufgenommen und
▪ ein Differenzsignal wird von der Auswerteeinrichtung als Differenz aus dem Messsignal und einem gespeicherten Kalibrationssignal bestimmt, wobei das Kalibrationssignal in Abwesenheit von elektrisch leitenden Messobjekten ermittelt wurde.

Das erfindungsgemäße Verfahren zum Detektieren von elektrisch leitenden Messobjekten in einem Untergrund wird mit Hilfe der erfindungsgemäßen Vorrichtung durchgeführt. Die Sendespuleneinrichtung umfasst eine oder mehrere Sendespulen und die Empfangsspuleneinrichtung umfasst eine oder mehrere Empfangsspulen. Mindestens eine Sendespule der Sendespuleneinrichtung wird von einem Strom I durchflossen, der zu einem Abschaltzeitpunkt t₀ von der Steuereinrichtung abgeschaltet wird. Die stromdurchflossenen Sendespulen erzeugen ein primäres Magnetfeld, das nach dem Abschalten des Stromes I abklingt. Beim Abschalten des Stromes I entstehen in elektrisch leitenden Fremd- und Störobjekten auf der Oberseite des Metallblechs Wirbelströme, deren sekundäre Magnetfelder dem primären Magnetfeld der Sendespuleneinrichtung gleichgerichtet sind. Die sekundären Magnetfelder erzeugen ihrerseits im Metallblech Wirbelströme, deren Magnetfelder den sekundären Magnetfeldern entgegengerichtet sind und das resultierende Magnetfeld abschwächen. Je schwächer das resultierende Magnetfeld ist, umso geringer ist der Einfluss von elektrisch leitenden Fremd- und Störobjekten auf die Messergebnisse der erfindungsgemäßen Vorrichtung.

Das resultierende Magnetfeld induziert in den Empfangsspulen der Empfangsspuleneinrichtung Spannungen. Die induzierten Spannungen der Empfangsspulen werden von der Auswerteeinrichtung als Messsignale aufgenommen. Das erfindungsgemäße Verfahren zum Detektieren von elektrisch leitenden Messobjekten arbeitet mit einem Differenzsignal, das als Differenz aus dem Messsignal und einem gespeicherten Kalibrationssignal gebildet wird. Das Kalibrationssignal wird mit Hilfe der erfindungsgemäßen Vorrichtung in Abwesenheit von elektrisch leitenden Messobjekten ermittelt und beispielsweise in einer Speichereinrichtung gespeichert.

Das erfindungsgemäße Verfahren zum Detektieren von elektrisch leitenden Messobjekten nutzt ein Metallblech, um den Einfluss von elektrisch leitenden Fremd- und Störobjekten auf die Messergebnisse zu reduzieren. Allerdings bildet das Metallblech selbst ein elektrisch leitendes Störobjekt, das die Messergebnisse beeinflusst. Durch eine Zeitverschiebung Δt, mit der Empfangssignale nach dem Abschaltzeitpunkt t₀ des Stromes von der Auswerteeinrichtung aufgenommen werden, kann die kompensierende Wirkung des Metallblechs überwiegen. Dazu müssen die Eigenschaften des Metallblechs und die Zeitverschiebung Δt, mit der die Empfangssignale nach dem Abschaltzeitpunkt t₀ des Stromes aufgenommen werden, aufeinander abgestimmt werden. Die Abstimmung erfolgt über die Auswahl eines geeigneten Metallblechs (Material und Blechdicke) und eine geeignete Zeitverschiebung Δt nach dem Abschaltzeitpunkt t₀ des Stromes in den Sendespulen der Sendespuleneinrichtung.

Bevorzugt ist die Zeitverschiebung Δt nicht kleiner als 5 µs. Im Rahmen des erfindungsgemäßen Verfahrens wird in mindestens einer Empfangsspule der Empfangsspuleneinrichtung von der Auswerteeinrichtung ein Messsignal aufgenommen, wobei die Aufnahme des Messsignals mit der Zeitverschiebung Δt nach dem Abschaltzeitpunkt t₀ des Stromes I erfolgt. Geeignete Werte für die Zeitverschiebung Δt sind unter anderem vom metallischen Material des Metallblechs und der Blechdicke des Metallblechs abhängig. Das erfindungsgemäße Verfahren nutzt das Differenzsignal aus Messsignal und Kalibrationssignal, die einen ähnlichen Zeitverlauf aufweisen. Nach dem Abschalten des Stroms lässt sich ein schneller Abfall der Amplituden der Empfangssignale beobachten, der durch das Eindringen der Wirbelströme von der Oberfläche bis ins Innere der elektrisch leitenden Objekte verursacht wird. Wenn die Wirbelströme die elektrisch leitenden Objekte voll durchfluten, geht der schnelle Abfall in einen langsameren Abfall der Empfangssignale über. Die Blechdicke des Metallblechs wird so eingestellt, dass in den Empfangssignalen (Mess- und Kalibrationssignale) der Übergang vom schnellen Abfall zum langsameren Abfall bei Zeitverschiebung Δt grösser als 5 µs stattfindet und die Amplituden der Empfangssignale beim Übergang unterhalb der Übersteuerungsgrenze liegen. Für Aluminiumbleche ist eine Blechdicke von mindestens 1,0 mm und für Kupferbleche eine Blechdicke von mindestens 0,4 mm erforderlich.

Bevorzugt ist die Zeitverschiebung Δt nicht grösser als 10 µs. Bei Zeitverschiebungen Δt, die kleiner oder gleich 10 µs sind, ist sichergestellt, dass die Effekte der elektrisch leitenden Messobjekte von der Auswerteeinrichtung im Messsignal ermittelt werden können. Wenn die Zeitverschiebungen Δt zu groß sind, d.h. grösser als 10 µs, sind die Effekte der elektrisch leitenden Messobjekte im Messsignal bereits zu stark abgeklungen.

Die Blechdicke des Metallblechs wird so eingestellt, dass in den Empfangssignalen (Mess- und Kalibrationssignale) der Übergang vom schnellen Abfall zum langsameren Abfall bei Zeitverschiebungen Δt zwischen 5 µs und 10 µs stattfindet und die Amplituden der Empfangssignale für diese Zeitverschiebungen Δt unterhalb der Übersteuerungsgrenze liegen.

### Ausführungsbeispiele

Ausführungsbeispiele der Erfindung werden nachfolgend anhand der Zeichnung beschrieben. Diese soll die Ausführungsbeispiele nicht notwendigerweise maßstäblich darstellen, vielmehr ist die Zeichnung, wo zur Erläuterung dienlich, in schematischer und/oder leicht verzerrter Form ausgeführt. Dabei ist zu berücksichtigen, dass vielfältige Modifikationen und Änderungen betreffend die Form und das Detail einer Ausführungsform vorgenommen werden können, ohne von der Erfindung wie in den Ansprüchen definiert abzuweichen.

Die Erfindung ist nicht beschränkt auf die exakte Form oder das Detail der im Folgenden gezeigten und beschriebenen bevorzugten Ausführungsform. Die Erfindung ist in den Ansprüchen definiert.

Es zeigen:
- FIG. 1: die Anwendung einer erfindungsgemäßen Vorrichtung zum Detektieren von elektrisch leitenden Messobjekten in einem Untergrund;
- FIGN. 2A, B: die erfindungsgemäße Vorrichtung der FIG. 1 in einer dreidimensionalen Darstellung (FIG. 2A) und die wesentlichen Komponenten der Vorrichtung, die ein Gehäuse, eine Magnetspuleneinrichtung, ein Metallblech, Steuer- und Auswerteeinrichtungen und eine Anzeigeeinrichtung mit einem Display umfassen, in einer Explosionsdarstellung (FIG. 2B);
- FIG. 3: die Anordnung der Komponenten der erfindungsgemäßen Vorrichtung im Gehäuse in einer schematischen Darstellung;
- FIG. 4: den Zeitverlauf eines Messsignals, eines Kalibrationssignals und eines Differenzsignals;
- FIGN. 5A, B: den Zeitverlauf der normierten Kalibrationssignale für drei Aluminiumbleche mit verschiedenen Blechdicken (FIG. 5A) und den Zeitverlauf der normierten Kalibrationssignale für drei Kupferbleche mit verschiedenen Blechdicken (FIG. 5B); und
- FIG. 6: den Verlauf des Integrals des normierten Kalibrationssignals der FIGN. 5A, B in Abhängigkeit von der Blechdicke d des Metallblechs für Aluminiumbleche und Kupferbleche.

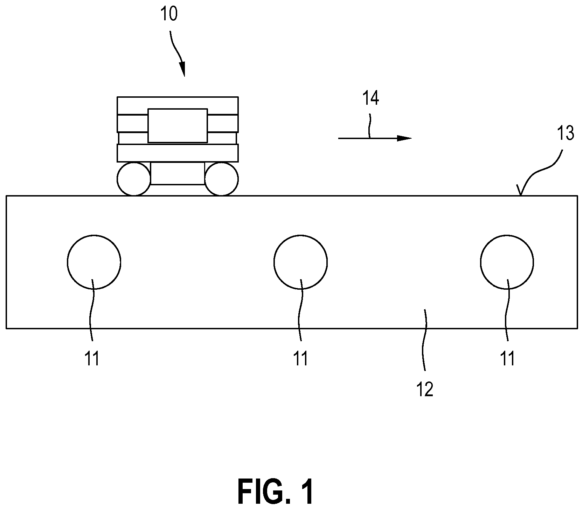

**FIG. 1** zeigt die Anwendung einer erfindungsgemäßen Vorrichtung **10** zum Detektieren von elektrisch leitenden Messobjekten **11** in einem Untergrund **12.** Die Vorrichtung 10 kann als gehaltene oder geführte Detektionsvorrichtung ausgebildet sein. Eine gehaltene Detektionsvorrichtung wird ohne Vorschubbewegung über eine Oberfläche **13** des zu detektierenden Untergrunds 12 gehalten und eine geführte Detektionsvorrichtung wird entlang einer linearen Bahn oder einer beliebigen Bahn über die Oberfläche 13 des zu detektierenden Untergrunds 12 geführt. Als handgehalten bzw. handgeführt wird eine Detektionsvorrichtung bezeichnet, die ein Bediener mit der Hand über die Oberfläche 13 des zu detektierenden Untergrunds 12 hält oder führt. FIG. 1 zeigt eine handgeführte Detektionsvorrichtung 10, die entlang einer Vorschubrichtung **14** über die Oberfläche 13 des Untergrunds 12 bewegt wird.

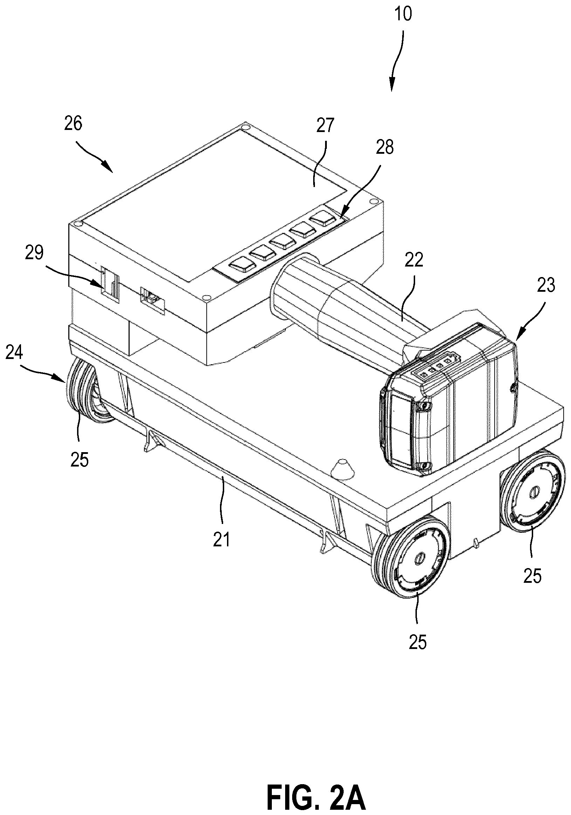

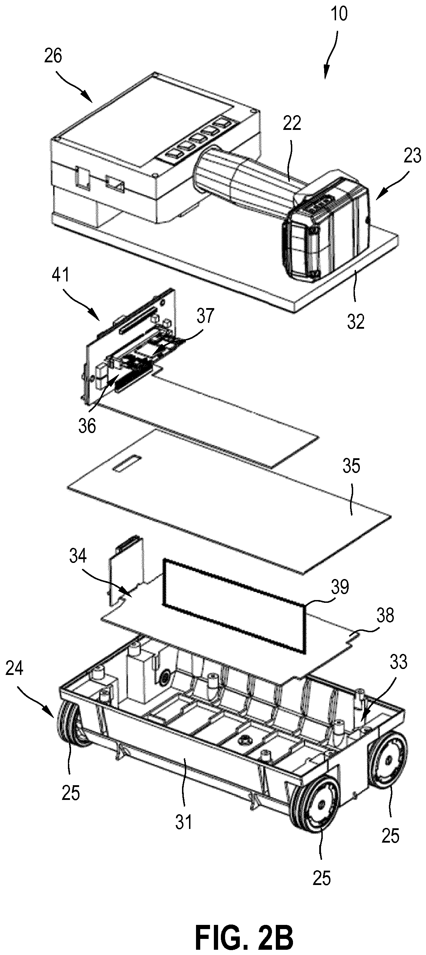

**FIGN. 2A****, B** zeigen die erfindungsgemäße Vorrichtung 10 in einer dreidimensionalen Darstellung (FIG. 2A) und die wesentlichen Komponenten der Vorrichtung 10 in einer Explosionsdarstellung (FIG. 2B).

FIG. 2A zeigt die Vorrichtung 10 im zusammengebauten Zustand. Die Vorrichtung 10 umfasst ein Gehäuse **21,** einen Handgriff **22,** eine Batterie **23,** eine Bewegungseinrichtung **24** mit vier Rädern **25,** eine Anzeigeeinrichtung **26** mit einem Display **27,** eine Bedienungseinrichtung **28** und Datenschnittstellen **29.** Der Benutzer führt die Vorrichtung 10 mit Hilfe des Handgriffes 22 und der Bewegungseinrichtung in der Vorschubrichtung 14 über den zu detektierenden Untergrund 12, der beispielsweise als Boden ausgebildet ist.

FIG. 2B zeigt die wesentlichen Komponenten der erfindungsgemäßen Vorrichtung 10 in einer Explosionsdarstellung. Die Vorrichtung 10 umfasst im Ausführungsbeispiel fünf Baugruppen, die ineinander gesteckt und zusammengebaut werden. Das Gehäuse 21 besteht aus einer unteren Gehäuseschale **31,** die mit der Bewegungseinrichtung 24 verbunden ist, und einem oberen Gehäusedeckel **32,** der mit der Anzeigeeinrichtung 26 verbunden ist. Die Gehäuseschale 31 und der Gehäusedeckel 32 umschließen im zusammengebauten Zustand einen Innenraum **33,** in dem eine Magnetspuleneinrichtung **34,** ein Metallblech **35,** eine Steuereinrichtung **36** und eine Auswerteeinrichtung **37** angeordnet werden.

Die Magnetspuleneinrichtung 34 umfasst eine Sendespuleneinrichtung **38,** die eine oder mehrere Sendespulen aufweist, und eine Empfangsspuleneinrichtung **39,** die eine oder mehrere Empfangsspulen aufweist. Die Anzahl der Sende- und Empfangsspulen, die Größe und Form der Sende- und Empfangsspulen und die räumliche Ausrichtung der Sende- und Empfangsspulen wird üblicherweise an die zu detektierenden elektrisch leitenden Messobjekte 11 angepasst, die mittels der erfindungsgemäßen Vorrichtung 10 gemessen werden sollen. Die Idee der erfindungsgemäßen Vorrichtung 10 ist unabhängig vom Aufbau der Sendespuleneinrichtung 38 und der Empfangsspuleneinrichtung 39.

Die Steuereinrichtung 36 ist zum Steuern der Sendespuleneinrichtung 38 und der Empfangsspuleneinrichtung 39 ausgebildet und mit der Magnetspuleneinrichtung 34 schaltungstechnisch verbunden. Die Auswerteeinrichtung 37 ist zum Auswerten der in den Empfangsspulen induzierten Spannung ausgebildet und mit der Magnetspuleneinrichtung 34 schaltungstechnisch verbunden. Unter dem Begriff "Auswerteeinrichtung" werden sämtliche Komponenten zur Signal- und Messwertverarbeitung der Empfangssignale, wie Verstärker, Filter oder Analog-Digital-Wandler, zusammengefasst. Die Steuereinrichtung 36 und Auswerteeinrichtung 37 sind im Ausführungsbeispiel in eine Kontrolleinrichtung **41** integriert.

Das Metallblech 35 kann mehrere Bohrungen aufweisen, die als Sackbohrungen oder Durchgangsbohrungen ausgebildet sein können. Die Bohrungen dienen zum einen als Haltepunkte für die Sende- und Empfangsspulen der Magnetspuleneinrichtung 34 und zum anderen als Durchlass für die schaltungstechnische Verbindung der Magnetspuleneinrichtung 34 mit der Steuereinrichtung 36 und der Auswerteeinrichtung 37.

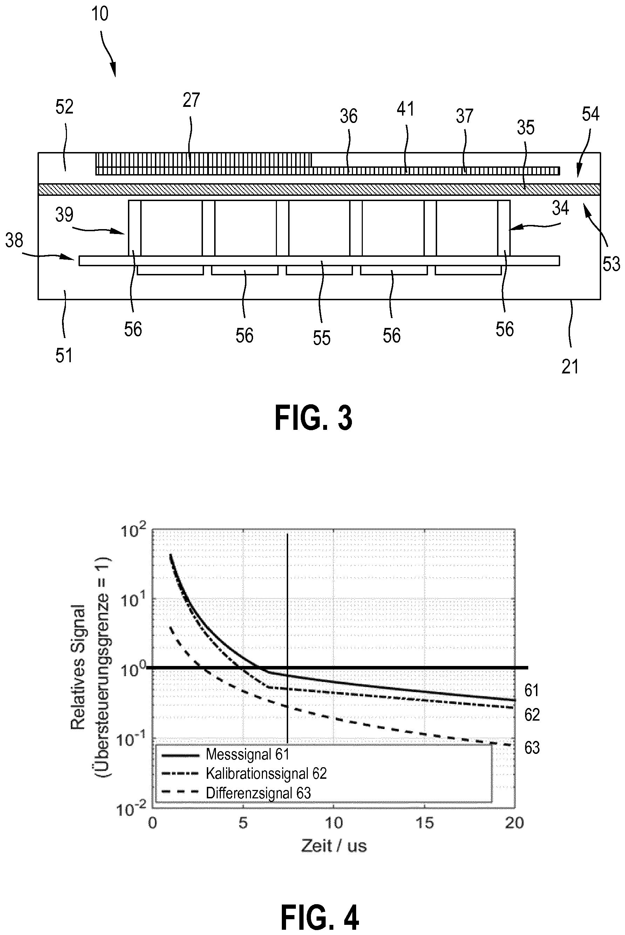

**FIG. 3** zeigt die Anordnung der Komponenten der Vorrichtung 10 im Gehäuse 21 in einer schematischen Darstellung. Das Metallblech 35 unterteilt den Innenraum 33 des Gehäuses 21 in einen unteren Teilbereich **51,** der dem zu detektierenden Untergrund 12 im Messbetrieb der Vorrichtung 10 zugewandt ist, und einen oberen Teilbereich **52,** der dem zu detektierenden Untergrund 12 im Messbetrieb der Vorrichtung 10 abgewandt ist. Die Magnetspuleneinrichtung 34 mit der Sendespuleneinrichtung 38 und der Empfangsspuleneinrichtung 39 ist im unteren Teilbereich 51 des Innenraums 33 angeordnet und die Steuereinrichtung 36 und Auswerteeinrichtung 37 sind im oberen Teilbereich 52 des Innenraums 33 angeordnet.

Grundsätzlich gilt für die Anordnung der Komponenten der Vorrichtung, dass die Magnetspuleneinrichtung 34 auf einer dem Untergrund 12 zugewandten Unterseite **53** des Metallblechs 35 angeordnet ist. Alle weiteren Komponenten der Vorrichtung 10, die leitende Materialien aufweisen und elektrisch leitende Störobjekte darstellen, sind auf einer dem Untergrund 12 abgewandten Oberseite **54** des Metallblechs 35 angeordnet. Dazu gehören neben der Steuereinrichtung 36 und Auswerteeinrichtung 37 die Anzeigeeinrichtung 26 mit dem Display 27, die Bedienungseinrichtung 28, die Datenschnittstellen 29 und die Batterie 23. Der Handgriff 22 ist oberhalb des Gehäusedeckels 32 angeordnet, so dass elektrisch leitende Fremdobjekte, wie eine Armbanduhr, Ringe oder sonstige Schmuckstücke, die ein Bediener im Messbetrieb der Vorrichtung 10 trägt, auf der abgewandten Oberseite 53 des Metallblechs 35 angeordnet sind.

Das Metallblech 35 ist aus einem Metall aufgebaut, wobei grundsätzlich alle Metalle geeignet sind. Aluminium, das als reines Aluminium oder Aluminiumlegierung ausgebildet ist, und Kupfer, das als reines Kupfer oder Kupferlegierung ausgebildet ist, sind als Metalle für das Metallblech 35 besonders geeignet. Unter dem Begriff "Metall" werden reine Metalle und Metalllegierungen zusammengefasst. Die Wirkung des Metallblechs 35 ist von mehreren Größen abhängig. Dazu gehören die elektrische Leitfähigkeit σ des Metalls, die magnetische Permeabilität µ des Metalls und die Blechdicke **d** des Metallblechs 35. Die elektrische Leitfähigkeit σ und die magnetische Permeabilität µ sind durch die Auswahl eines Metalls festgelegt, die Blechdicke d des Metallblechs 35 kann bei festgelegtem Metall verändert werden. Über die Auswahl der Blechdicke d des Metallblechs 35 kann das Abklingverhalten der Wirbelströme im Metallblech 35 beeinflusst werden.

Im Ausführungsbeispiel umfasst die Sendespuleneinrichtung 38 eine Sendespule **55** und die Empfangsspuleneinrichtung 39 mehrere Empfangsspulen **56.** Alternativ kann die Sendespuleneinrichtung 38 mehrere Sendespulen 55 oder die Empfangsspuleneinrichtung 39 eine Empfangsspule 56 aufweisen. Die Anzahl, Ausrichtung und/oder Größe der Sendespulen 55 sowie die Anzahl, Ausrichtung und/oder Größe der Empfangsspulen 56 werden an die elektrisch leitenden Messobjekte 11 angepasst, die mittels der erfindungsgemäßen Vorrichtung 10 gemessen werden sollen. Die Idee der erfindungsgemäßen Vorrichtung 10 ist unabhängig vom Aufbau der Sendespuleneinrichtung 38 und der Empfangsspuleneinrichtung 39.

Die Sendespule 55 wird von einem Strom I durchflossen und erzeugt ein primäres Magnetfeld. Der Strom I wird von der Steuereinrichtung 36 abgeschaltet, so dass das primäre Magnetfeld abklingt. Das primäre Magnetfeld induziert beim Ausschalten des Stromes in elektrisch leitenden Objekten Wirbelströme, die sekundäre Magnetfelder erzeugen, wobei die sekundären Magnetfelder erheblich langsamer abklingen als das primäre Magnetfeld. Das primäre Magnetfeld wird von den sekundären Magnetfeldern der elektrisch leitenden Objekte zu einem resultierenden Magnetfeld überlagert.

Das Metallblech 35 und das Messverfahren müssen so aufeinander abgestimmt werden, dass während der Aufnahme der Messsignale einerseits die unerwünschten Wirbelströme, die von elektrischen leitenden Fremd- und Störobjekten erzeugt werden, ausreichend stark abgeklungen sind, und andererseits die erwünschten Ströme, die von den elektrisch leitenden Messobjekten 11 im Untergrund 12 erzeugt werden, noch nicht zu stark abgeklungen sind.

**FIG. 4** zeigt den Zeitverlauf eines Messsignals **61,** das mittels der Vorrichtung 10 gemessen wurde. Um Effekte, wie Sekundärfelder von elektrisch leitenden Störobjekten, zu eliminieren, ist in der Vorrichtung 10 ein Kalibrationssignal **62** gespeichert, das in Abwesenheit von elektrisch leitenden Messobjekten 11 mittels der Vorrichtung 10 aufgenommen wurde. Die Auswertung erfolgt anhand eines Differenzsignals **63,** das durch Differenzbildung aus dem Messsignal 61 und dem Kalibrationssignal 62 gebildet wird.

Die Vorrichtung 10 umfasst die Magnetspuleneinrichtung 34 mit der Sendespuleneinrichtung 38 und der Empfangsspuleneinrichtung 39, die Steuereinrichtung 36 und die Auswerteeinrichtung 37 mit der ersten und zweiten Auswerteeinrichtung. Im Messbetrieb der Vorrichtung 10 wird die Sendespulen 55 von einem Strom I durchflossen und der Strom I wird zu einem Abschaltzeitpunkt t₀ von der Steuereinrichtung 36 abgeschaltet. In den Empfangsspulen 56 werden Spannungen induziert, die von der Auswerteeinrichtung 37 als Empfangssignale aufgenommen werden. Die Empfangssignale der Empfangsspuleneinrichtung 38 werden in Abwesenheit von elektrisch leitenden Messobjekten 11 als Kalibrationssignale und in Anwesenheit von elektrisch leitenden Messobjekten 11 als Messsignale bezeichnet.

Die Auswerteeinrichtung 37 der erfindungsgemäßen Vorrichtung 10 beeinflusst das Messeverfahren insofern, als dass die Auswerteeinrichtung 37 eine Übersteuerungsgrenze für die Empfangssignale aufweist. Die Übersteuerungsgrenze ist eine Größe der Auswerteeinrichtung 37, die angibt, wann ein Übersteuern der Auswerteeinrichtung 37 auftritt. Die Übersteuerungsgrenze ist beispielsweise abhängig von der Referenzspannung der Analog-Digital-Wandler der Auswerteeinrichtung. Eingangsspannungen der Analog-Digital-Wandler, die grösser als diese Referenzspannung sind, führen zu einer Übersteuerung. Die Höhe der Eingangsspannungen hängen von der Stärke des Magnetfeldes der Wirbelströme am Ort der Empfangsspulen, der Geometrie der Empfangsspulen und der verwendeten Verstärkung ab. Die Empfangssignale der Empfangsspuleneinrichtung 39 sind auf die Übersteuerungsgrenze normiert. Eine Aufbereitung und Auswertung der Empfangssignale ist nur unterhalb der Übersteuerungsgrenze möglich; solange die Amplituden der Empfangssignale oberhalb der Übersteuerungsgrenze liegen, kann die Auswerteeinrichtung 37 keine Aufbereitung und Auswertung der Empfangssignale durchführen.

Das Messsignal 61 und das Kalibrationssignal 62 weisen grundsätzlich einen ähnlichen Zeitverlauf auf: Nach dem Abschalten des Stroms in der Sendespuleneinrichtung 38 lässt sich ein schneller Abfall der Amplituden der Empfangssignale beobachten, der in einen langsameren Abfall übergeht. Der schnelle Abfall der Empfangssignale tritt unmittelbar nach dem Abschalten des Stromes I auf und beschreibt das Eindringen der Wirbelströme von der Oberfläche bis ins Innere der elektrisch leitenden Objekte. Wenn die Wirbelströme die elektrisch leitenden Objekte voll durchfluten, geht der schnelle Abfall in einen langsameren Abfall der Empfangssignale über.

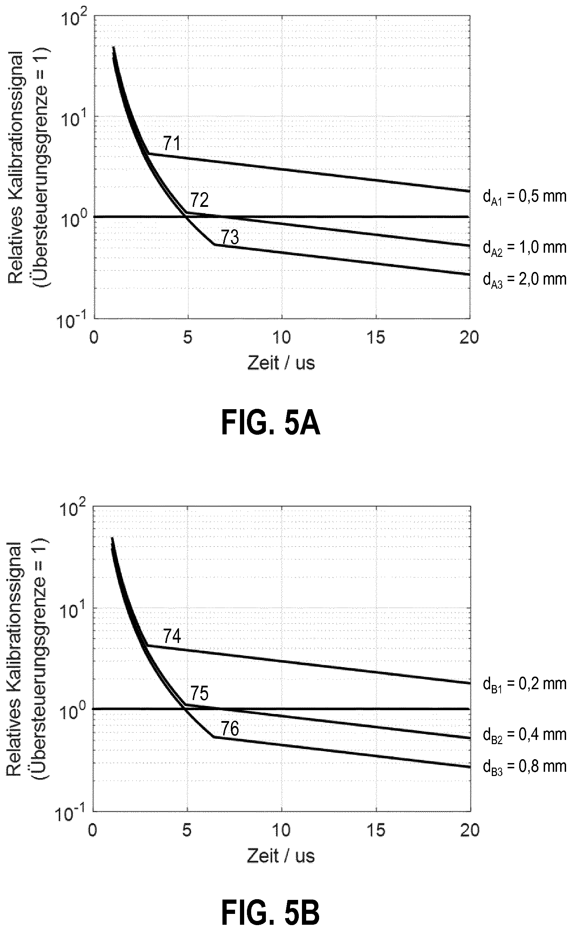

**FIGN. 5A****, B** zeigen den Zeitverlauf von normierten Kalibrationssignalen **71, 72, 73, 74, 75, 76** für verschiedene Metallbleche. Dabei zeigt FIG. 5A den Zeitverlauf der normierten Kalibrationssignale 71, 72, 73 für drei Metallbleche aus Aluminium, die im Folgenden als Aluminiumbleche bezeichnet werden, und FIG. 5B den Zeitverlauf der normierten Kalibrationssignale 74, 75, 76 für drei Metallbleche aus Kupfer, die im Folgenden als Kupferbleche bezeichnet werden.

Die Aluminiumbleche der FIG. 5A sind aus reinem Aluminium (Anteil von Aluminium grösser als 99,5 %) mit einer elektrischen Leitfähigkeit σ_{A} von 37·10⁶ S/m und einer magnetischen Permeabilität µ_{A} von 1,000022 H/m gefertigt und unterscheiden sich in den Blechdicken voneinander. Das erste Aluminiumblech weist eine erste Blechdicke **d_{A1}** von 0,5 mm auf, das zweite Aluminiumblech eine zweite Blechdicke **d_{A2}** von 1,0 mm und das dritte Aluminiumblech eine dritte Blechdicke **d_{A3}** von 2,0 mm. Die Kupferbleche der FIG. 5B sind aus reinem Kupfer (Anteil von Kupfer grösser als 99,5 %) mit einer elektrischen Leitfähigkeit σ_{B} von 58·10⁶ S/m und einer magnetischen Permeabilität **µ_{B}** von 0,9999936 H/m gefertigt und unterscheiden sich in den Blechdicken voneinander. Das erste Kupferblech weist eine erste Blechdicke **d_{B1}** von 0,2 mm auf, das zweite Kupferblech eine zweite Blechdicke **d_{B2}** von 0,4 mm und das dritte Kupferblech eine dritte Blechdicke **d_{B3}** von 0,8 mm.

Der Zeitverlauf der normierten Kalibrationssignale 71-76 zeigt, dass die Blechdicke d des Metallblechs 35 den Zeitverlauf der Kalibrationssignale verändert. Je dicker das Metallblech 35 ist, umso länger dauert es, bis die Wirbelströme die elektrisch leitenden Objekte voll durchfluten und der schnelle Abfall in den langsameren Abfall übergeht. Die Zeitverschiebung Δt nach dem Abschalten des Stromes in der Sendespuleneinrichtung 38 wird so gewählt, dass der schnelle Abfall des Empfangssignals abgeklungen ist. Gleichzeitig darf die Zeitverschiebung Δt nicht zu groß gewählt werden, da mit zunehmender Zeitverschiebung Δt die erwünschten Effekte der elektrisch leitenden Messobjekte in den Messsignalen abklingen.

Die Kalibrationssignale 71, 74 gehen bei ca. 3 µs vom schnellen Abfall in den langsameren Abfall über, wobei die Amplituden beim Übergang deutlich oberhalb der Übersteuerungsgrenze liegen. Da die Amplituden der Kalibrationssignale 71, 74 auch für Zeitverschiebungen Δt grösser als 20 µs nach dem Abschalten des Stromes oberhalb der Übersteuerungsgrenze liegen, sind das erste Aluminiumblech und das erste Kupferblech für die eingesetzte Auswerteeinrichtung 37 der Vorrichtung 10 ungeeignet.

Die Kalibrationssignale 72, 75 gehen bei ca. 5 µs vom schnellen Abfall in den langsameren Abfall über, wobei die Amplituden beim Übergang geringfügig oberhalb der Übersteuerungsgrenze liegen. Um ein Übersteuern der Auswerteeinrichtung 37 zu verhindern, sollten die maximalen Amplituden einen Maximalwert nicht übersteigen. Da die Kalibrationssignale auf die Übersteuerungsgrenze normiert sind, lässt sich der Maximalwert als Prozentanteil der Übersteuerungsgrenze (0 % bis 100 %) angeben. Als Maximalwert eignet sich beispielsweise ein Prozentanteil von 50 % der Übersteuerungsgrenze. Die Amplituden fallen bei den Kalibrationssignalen 72, 75 erst für Zeitverschiebungen Δt grösser 20 µs unter die Grenze von ca. 50 % der Übersteuerungsgrenze, so dass das zweite Aluminiumblech und das zweite Kupferblech für die eingesetzte Auswerteeinrichtung 37 nur bedingt geeignet sind. Wenn für den Maximalwert statt des Prozentanteils von 50 % der Übersteuerungsgrenze ein Prozentanteil von 70 % der Übersteuerungsgrenze definiert wird, fallen die Amplituden bei den Kalibrationssignalen 72, 75 für Zeitverschiebungen Δt grösser 13 µs unter den Maximalwert. Die Definition eines geeigneten Maximalwerts hängt unter anderem von der Auswerteeinrichtung 37 ab.

Die Kalibrationssignale 73, 76 gehen bei ca. 6 µs vom schnellen Abfall in den langsameren Abfall über, wobei die Amplituden beim Übergang bereits unterhalb der Übersteuerungsgrenze liegen. Die Amplituden fallen bei den Kalibrationssignalen für Zeitverschiebungen grösser 7 µs unter die Grenze von ca. 50 % der Übersteuerungsgrenze, so dass das dritte Aluminiumblech und das dritte Kupferblech für die eingesetzte Auswerteeinrichtung 37 geeignet sind. Als Zeitverschiebung Δt nach dem Abschalten des Stromes in der Sendespuleneinrichtung 38 eignen sich bei den Kalibrationssignalen 73, 76 ein Wert von ca. 7 µs. Wenn für den Maximalwert statt des Prozentanteils von 50 % der Übersteuerungsgrenze ein Prozentanteil von 70 % der Übersteuerungsgrenze definiert wird, fallen die Amplituden bei den Kalibrationssignalen für Zeitverschiebungen Δt grösser 6 µs unter den Maximalwert.

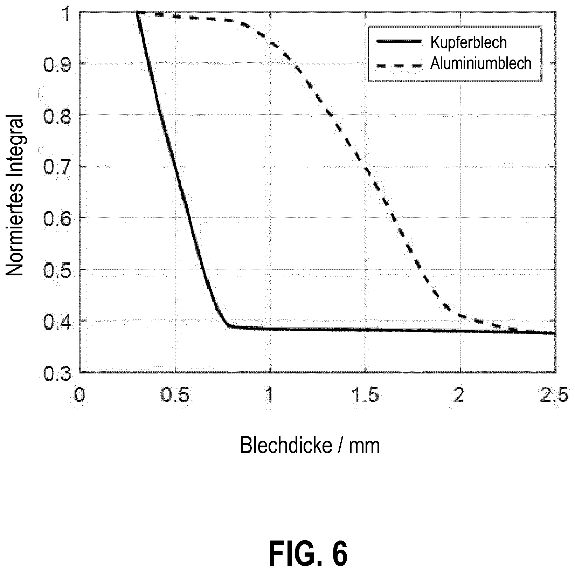

**FIG. 6** zeigt den normierten Verlauf der integrierten Kalibrationssignale aus FIGN. 5A, B in Abhängigkeit von der Blechdicke d des Metallblechs 35 für Metallbleche aus Aluminium (Aluminiumbleche) und für Metallbleche aus Kupfer (Kupferbleche). Dabei ist zu beachten, dass Amplituden über 1 in den FIGN. 5A, B wegen Übersteuerung nicht messbar sind und das gemessene Kalibrationssignal in diesem Bereich den Sättigungswert 1 besitzt. Die in FIG. 6 dargestellten integrierten Kalibrationssignale sind ebenfalls auf die Übersteuerungsgrenze normiert.

Der Verlauf der integrierten Kalibrationssignale für die verwendeten Kupferbleche zeigt, dass für Blechdicken kleiner 0,35 mm ein Übersteuern der Auswerteeinrichtung 37 auftritt und für Blechdicken grösser 0,8 mm günstige Messbedingungen vorliegen. Bei den verwendeten Aluminiumblechen tritt für Blechdicken kleiner 1,0 mm ein Übersteuern der Auswerteeinrichtung 37 auf und für Blechdicken grösser 2,0 mm liegen günstige Messbedingungen vor.

## Patentansprüche

1. Vorrichtung (10) zum Detektieren von elektrisch leitenden Messobjekten (11) in einem Untergrund (12), wobei die Vorrichtung (10) im Messbetrieb in einer Messausrichtung über eine Oberfläche (13) des Untergrunds (12) bewegt wird, aufweisend:
▪ ein Gehäuse (21),
▪ eine im Gehäuse (21) angeordnete Magnetspuleneinrichtung (34), die eine Sendespuleneinrichtung (38) mit mindestens einer Sendespule (55) und eine Empfangsspuleneinrichtung (39) mit mindestens einer Empfangsspule (56) umfasst,
▪ eine Steuereinrichtung (36), die mit der Magnetspuleneinrichtung (34) verbunden ist und die zum Steuern der Sendespuleneinrichtung (38) und zum Steuern der Empfangsspuleneinrichtung (39) ausgebildet ist, und
▪ eine Auswerteeinrichtung (37), die mit der Magnetspuleneinrichtung (34) verbunden ist und die zum Aufbereiten und Auswerten einer in der Empfangsspuleneinrichtung (39) induzierten Spannung als Messsignal (61) ausgebildet ist,
**dadurch gekennzeichnet, dass** im Gehäuse (21) ein Metallblech (35) mit einer Blechdicke (d) vorgesehen ist, wobei das Metallblech (35) im Messbetrieb im Wesentlichen parallel zur Oberfläche (13) des Untergrunds (12) angeordnet ist, die Magnetspuleneinrichtung (34) auf einer im Messbetrieb dem Untergrund (12) zugewandten Unterseite (53) des Metallblechs (35) angeordnet ist und die Steuereinrichtung (36) auf einer im Messbetrieb dem Untergrund (12) abgewandten Oberseite (54) des Metallblechs (35) angeordnet ist.

2. Vorrichtung nach Anspruch 1, **dadurch gekennzeichnet, dass** die Auswerteeinrichtung (37) eine erste Auswerteeinrichtung, die die Messsignale (61) aufbereitet, und eine zweite Auswerteeinrichtung, die die Messsignale (61) auswertet, umfasst, wobei die erste Auswerteeinrichtung auf der im Messbetrieb dem Untergrund (12) abgewandten Oberseite (54) des Metallblechs (35) angeordnet ist.

3. Vorrichtung nach Anspruch 2, **dadurch gekennzeichnet, dass** die zweite Auswerteeinrichtung auf der im Messbetrieb dem Untergrund (12) abgewandten Oberseite (54) des Metallblechs (35) angeordnet ist.

4. Vorrichtung nach Anspruch 2, **dadurch gekennzeichnet, dass** die zweite Auswerteeinrichtung außerhalb des Gehäuses (21) angeordnet ist, wobei die erste und zweite Auswerteeinrichtung über eine Kommunikationsverbindung verbindbar sind.

5. Vorrichtung nach Anspruch 1, **dadurch gekennzeichnet, dass** das Gehäuse (21) einen Innenraum (33) umschließt und das Metallblech (35) den Innenraum (33) in einen unteren Teilbereich (51) und einen oberen Teilbereich (52) unterteilt, wobei die Magnetspuleneinrichtung (34) im unteren Teilbereich (51) und die Steuereinrichtung (36) und die erste Auswerteeinrichtung (36, 37) im oberen Teilbereich (52) angeordnet sind.

6. Vorrichtung nach Anspruch 1, **gekennzeichnet durch** eine Anzeigeeinrichtung (26) mit einem Display (27), das zur Anzeige eines von der Auswerteeinrichtung (37) berechneten Messergebnisses ausgebildet ist, wobei das Display (27) auf der im Messbetrieb dem Untergrund (12) abgewandten Oberseite (54) des Metallblechs (35) angeordnet ist.

7. Vorrichtung nach Anspruch 2, **gekennzeichnet durch** eine Speichereinrichtung, die mit der Auswerteeinrichtung (37) datenübertragend verbunden ist und in der ein Kalibrationssignal (62) gespeichert ist, wobei das Kalibrationssignal (62) in Abwesenheit von elektrisch leitenden Messobjekten (11) ermittelt wurde.

8. Vorrichtung nach einem der Ansprüche 1 bis 7, **dadurch gekennzeichnet, dass** das Metallblech (35) aus Aluminium aufgebaut ist, wobei das Metallblech (35) eine Blechdicke (d) von mindestens 1,0 mm aufweist.

9. Vorrichtung nach Anspruch 8, **dadurch gekennzeichnet, dass** das Metallblech (35) eine Blechdicke (d) von mindestens 2,0 mm aufweist.

10. Vorrichtung nach einem der Ansprüche 1 bis 7, **dadurch gekennzeichnet, dass** das Metallblech (35) aus Kupfer aufgebaut ist, wobei das Metallblech (35) eine Blechdicke (d) von mindestens 0,4 mm aufweist.

11. Vorrichtung nach Anspruch 10, **dadurch gekennzeichnet, dass** das Metallblech (35) eine Blechdicke (d) von mindestens 0,8 mm aufweist.

12. Verfahren zum Detektieren von elektrisch leitenden Messobjekten (11) in einem Untergrund (12) mit einer Vorrichtung (10) nach einem der Ansprüche 1 bis 11, die eine Sendespuleneinrichtung (38), eine Empfangsspuleneinrichtung (39), eine Steuereinrichtung (36) und eine Auswerteeinrichtung (37) umfasst, aufweisend eine Schrittfolge mit den Schritten:
▪ mindestens eine Sendespule (55) der Sendespuleneinrichtung (38) wird von einem Strom (I) durchflossen,
▪ der Strom (I) wird zu einem Abschaltzeitpunkt (t₀) von der Steuereinrichtung (36) abgeschaltet,
▪ eine, in mindestens einer Empfangsspule (56) der Empfangsspuleneinrichtung (39) induzierte Spannung wird von der Auswerteeinrichtung (37) mit einer Zeitverschiebung (Δt) nach dem Abschaltzeitpunkt (t₀) des Stromes (I) als Messsignal (61) aufgenommen und
▪ ein Differenzsignal (63) wird von der Auswerteeinrichtung (37) als Differenz aus dem Messsignal (61) und einem gespeicherten Kalibrationssignal (62) bestimmt, wobei das Kalibrationssignal (62) in Abwesenheit von elektrisch leitenden Messobjekten (11) ermittelt wurde.

13. Verfahren nach Anspruch 12, **dadurch gekennzeichnet, dass** die Zeitverschiebung (Δt) nicht kleiner als 5 µs ist.

14. Verfahren nach einem der Ansprüche 12 bis 13, **dadurch gekennzeichnet, dass** die Zeitverschiebung (Δt) nicht grösser als 10 µs ist.

## Claims

1. Device (10) for detecting electrically conductive measurement objects (11) in a substrate (12), wherein the device (10), in measuring mode, is moved in a measurement orientation across a surface (13) of the substrate (12), having:
• a housing (21),
• a magnetic coil apparatus (34) arranged in the housing (21) and comprising a transmission coil apparatus (38) having at least one transmission coil (55) and a reception coil apparatus (39) having at least one reception coil (56),
• a control apparatus (36) that is connected to the magnetic coil apparatus (34) and that is designed to control the transmission coil apparatus (38) and to control the reception coil apparatus (39), and
• an evaluation apparatus (37) that is connected to the magnetic coil apparatus (34) and that is designed to process and evaluate a voltage induced in the reception coil apparatus (39) as a measured signal (61),
**characterized in that** a metal sheet (35) having a sheet thickness (d) is provided in the housing (21), wherein the metal sheet (35), in measuring mode, is arranged substantially parallel to the surface (13) of the substrate (12), the magnetic coil apparatus (34) is arranged on a lower side (53), facing the substrate (12) in measuring mode, of the metal sheet (35) and the control apparatus (36) is arranged on an upper side (54), facing away from the substrate (12) in measuring mode, of the metal sheet (35).

2. Device according to Claim 1, **characterized in that** the evaluation apparatus (37) comprises a first evaluation apparatus that processes the measured signals (61) and a second evaluation apparatus that evaluates the measured signals (61), wherein the first evaluation apparatus is arranged on the upper side (54), facing away from the substrate (12) in measuring mode, of the metal sheet (35) .

3. Device according to Claim 2, **characterized in that** the second evaluation apparatus is arranged on the upper side (54), facing away from the substrate (12) in measuring mode, of the metal sheet (35).

4. Device according to Claim 2, **characterized in that** the second evaluation apparatus is arranged outside the housing (21), wherein the first and second evaluation apparatus are able to be connected via a communication connection.

5. Device according to Claim 1, **characterized in that** the housing (21) encloses an interior (33) and the metal sheet (35) divides the interior (33) into a lower subregion (51) and an upper subregion (52), wherein the magnetic coil apparatus (34) is arranged in the lower subregion (51) and the control apparatus (36) and the first evaluation apparatus (36, 37) are arranged in the upper subregion (52).

6. Device according to Claim 1, **characterized by** a display apparatus (26) having a display (27) that is designed to display a measurement result computed by the evaluation apparatus (37), wherein the display (27) is arranged on the upper side (54), facing away from the substrate (12) in measuring mode, of the metal sheet (35) .

7. Device according to Claim 2, **characterized by** a storage apparatus that is connected to the evaluation apparatus (37) so as to transmit data and in which a calibration signal (62) is stored, wherein the calibration signal (62) has been ascertained in the absence of any electrically conductive measurement objects (11).

8. Device according to one of Claims 1 to 7, **characterized in that** the metal sheet (35) is made of aluminium, wherein the metal sheet (35) has a sheet thickness (d) of at least 1.0 mm.

9. Device according to Claim 8, **characterized in that** the metal sheet (35) has a sheet thickness (d) of at least 2.0 mm.

10. Device according to one of Claims 1 to 7, **characterized in that** the metal sheet (35) is made of copper, wherein the metal sheet (35) has a sheet thickness (d) of at least 0.4 mm.

11. Device according to Claim 10, **characterized in that** the metal sheet (35) has a sheet thickness (d) of at least 0.8 mm.

12. Method for detecting electrically conductive measurement objects (11) in a substrate (12) using a device (10) according to one of Claims 1 to 11, which device comprises a transmission coil apparatus (38), a reception coil apparatus (39), a control apparatus (36) and an evaluation apparatus (37), having a sequence of steps comprising the following steps:
• at least one transmission coil (55) of the transmission coil apparatus (38) is flowed through by a current (I),
• the current (I) is deactivated by the control apparatus (36) at a deactivation time (t₀),
• a voltage induced in at least one reception coil (56) of the reception coil apparatus (39) is received as measured signal (61) by the evaluation apparatus (37) with a time difference (Δt) following the deactivation time (t₀) of the current (I) and
• a differential signal (63) is determined by the evaluation apparatus (37) as a difference from the measurement signal (61) and a stored calibration signal (62), wherein the calibration signal (62) has been ascertained in the absence of any electrically conductive measurement objects (11).

13. Method according to Claim 12, **characterized in that** the time difference (Δt) is not less than 5 µs.

14. Method according to either of Claims 12 and 13, **characterized in that** time difference (Δt) is not greater than 10 µs.

## Revendications

1. Dispositif (10) permettant de détecter des objets de mesure électroconducteurs (11) dans un sol (12), le dispositif (10) étant déplacé en mode de mesure dans une orientation de mesure sur une surface (13) du sol (12), présentant :
- un boîtier (21),
- un dispositif à bobines magnétiques (34) disposé dans le boîtier (21) et qui comprend un dispositif à bobine émettrice (38) pourvu d'au moins une bobine émettrice (55) et un dispositif à bobine réceptrice (39) pourvu d'au moins une bobine réceptrice (56),
- un dispositif de commande (36) qui est relié au dispositif à bobines magnétiques (34) et qui est réalisé pour commander le dispositif à bobine émettrice (38) et pour commander le dispositif à bobine réceptrice (39), et
- un dispositif d'évaluation (37) qui est relié au dispositif à bobines magnétiques (34) et qui est réalisé pour traiter et évaluer comme signal de mesure (61) une tension induite dans le dispositif à bobine réceptrice (39),
**caractérisé en ce que** dans le boîtier (21), une tôle métallique (35) d'une épaisseur de tôle (d) est prévue, la tôle métallique (35) en mode de mesure étant disposée de manière substantiellement parallèle à la surface (13) du sol (12), le dispositif à bobines magnétiques (34) étant disposé sur une face inférieure (53) de la tôle métallique (35), tournée vers le sol (12) en mode de mesure, et le dispositif de commande (36) étant disposé sur une face supérieure (54) de la tôle métallique (35), tournée vers le sol (12) en mode de mesure.

2. Dispositif selon la revendication 1, **caractérisé en ce que** le dispositif d'évaluation (37) comprend un premier dispositif d'évaluation qui traite les signaux de mesure (61), et un deuxième dispositif d'évaluation qui évalue les signaux de mesure (61), le premier dispositif d'évaluation étant disposé sur la face supérieure (54) de la tôle métallique (35), détournée du sol (12) en mode de mesure.

3. Dispositif selon la revendication 2, **caractérisé en ce que** le deuxième dispositif d'évaluation est disposé sur la face supérieure (54) de la tôle métallique (35), détournée du sol (12) en mode de mesure.

4. Dispositif selon la revendication 2, **caractérisé en ce que** le deuxième dispositif d'évaluation est disposé à l'extérieur du boîtier (21), le premier et le deuxième dispositif d'évaluation pouvant être reliés par une liaison de communication.

5. Dispositif selon la revendication 1, **caractérisé en ce que** le boîtier (21) enferme un espace intérieur (33) et la tôle métallique (35) divise l'espace intérieur (33) en une zone partielle inférieure (51) et une zone partielle supérieure (52), le dispositif à bobines magnétiques (34) étant disposé dans la zone partielle inférieure (51) et le dispositif de commande (36) et le premier dispositif d'évaluation (36, 37) étant disposés dans la zone partielle supérieure (52).

6. Dispositif selon la revendication 1, **caractérisé par** un dispositif d'affichage (26) pourvu d'un écran d'affichage (27) qui est réalisé pour afficher un résultat de mesure calculé par le dispositif d'évaluation (37), l'écran d'affichage (27) étant disposé sur la face supérieure (54) de la tôle métallique (35), détournée du sol (12) en mode de mesure.

7. Dispositif selon la revendication 2, **caractérisé par** un dispositif de mémoire qui est relié en transmission de données au dispositif d'évaluation (37) et dans lequel est stocké un signal d'étalonnage (62), le signal d'étalonnage (62) ayant été établi en l'absence de tout objet de mesure électroconducteur (11).

8. Dispositif selon l'une quelconque des revendications 1 à 7, **caractérisé en ce que** la tôle métallique (35) est composée d'aluminium, la tôle métallique (35) présentant une épaisseur de tôle (d) d'au moins 1,0 mm.

9. Dispositif selon la revendication 8, **caractérisé en ce que** la tôle métallique (35) présente une épaisseur de tôle (d) d'au moins 2,0 mm.

10. Dispositif selon l'une quelconque des revendications 1 à 7, **caractérisé en ce que** la tôle métallique (35) est composée de cuivre, la tôle métallique (35) présentant une épaisseur de tôle (d) d'au moins 0,4 mm.

11. Dispositif selon la revendication 10, **caractérisé en ce que** la tôle métallique (35) présente une épaisseur de tôle (d) d'au moins 0,8 mm.

12. Procédé permettant de détecter des objets de mesure électroconducteurs (11) dans un sol (12), comprenant un dispositif (10) selon l'une quelconque des revendications 1 à 11 qui comprend un dispositif à bobine émettrice (38), un dispositif à bobine réceptrice (39), un dispositif de commande (36) et un dispositif d'évaluation (37), présentant une séquence d'étapes comprenant les étapes suivantes :
- au moins une bobine émettrice (55) du dispositif à bobine émettrice (38) est parcourue par un courant (I),
- le courant (I) est déconnecté du dispositif de commande (36) à un instant de déconnexion (t₀),
- une tension induite dans au moins une bobine réceptrice (56) du dispositif à bobine réceptrice (39) est enregistrée comme signal de mesure (61) par le dispositif d'évaluation (37) avec un décalage dans le temps (Δt) après l'instant de déconnexion (t₀) du courant (I), et
- un signal différentiel (63) est déterminé par le dispositif d'évaluation (37) comme la différence entre le signal de mesure (61) et un signal d'étalonnage stocké (62), le signal d'étalonnage (62) ayant été établi en l'absence de tout objet de mesure électroconducteur (11).

13. Procédé selon la revendication 12, **caractérisé en ce que** le décalage dans le temps (Δt) n'est pas inférieur à 5 µs.

14. Procédé selon l'une quelconque des revendications 12 à 13, **caractérisé en ce que** le décalage dans le temps (Δt) n'est pas supérieur à 10 µs.
